Europäisches Patentamt

European Patent Office

Office européen des brevets

(19)

(11) Veröffentlichungsnummer: **0 184 670**
**B1**

(12) # EUROPÄISCHE PATENTSCHRIFT

(45) Veröffentlichungstag der Patentschrift:
07.03.90

(21) Anmeldenummer: 85114147.3

(22) Anmeldetag: 06.11.85

(51) Int. Cl.⁴: **G01R 33/035**, G01R 33/022,
H01L 39/24

(54) Verfahren zur Herstellung eines supraleitenden Gradiometers mit dreidimensionaler Struktur für eine Vorrichtung zur Messung schwacher Magnetfelder.

(30) Priorität: 19.11.84 DE 3442269

(43) Veröffentlichungstag der Anmeldung:
18.06.86 Patentblatt 86/25

(45) Bekanntmachung des Hinweises auf die Patenterteilung:
07.03.90 Patentblatt 90/10

(84) Benannte Vertragsstaaten:
DE FR NL

(56) Entgegenhaltungen:
EP-A- 0 111 827
FR-A- 2 540 253
US-A- 4 266 008
US-A- 4 280 095

(73) Patentinhaber: Siemens Aktiengesellschaft,
Wittelsbacherplatz 2, D-8000 München 2(DE)

(72) Erfinder: Daalmans, Gabriel M., Ungarnstrasse 11,
D-8520 Erlangen(DE)

## Beschreibung

Die Erfindung bezieht sich auf ein Verfahren zur Herstellung eines Gradiometers aus supraleitendem Material mit dreidimensionaler Gestalt für eine Vorrichtung zur ein- oder mehrkanaligen Messung von Magnetfeldern mit Feldstärken bis unter $10^{-10}$ T, insbesondere unter $10^{-12}$ T, bei dem die Gradiometerspulen vorbestimmter Abmessungen auf einem Trägerkörper angeordnet und mittels Verbindungsleitungen und einer Koppelspule mit einem auf einem eigenen Substratkörper befindlichen supraleitenden Quanten-Interferenz-Element (SQUID) in magnetisch koppelnder Weise verbunden werden. Ein derartiges Verfahren ist in "Review of Scientific Instruments", Vol. 53, No. 12, Dez. 1982, Seiten 1815 bis 1845 angedeutet.

Die Verwendung von supraleitenden Quanten-Interferenz-Elementen, die allgemein als "SQUIDs" (Abkürzung von "Superconducting Quantum Interference Devices") bezeichnet werden, zur Messung sehr schwacher magnetischer Felder ist allgemein bekannt (J. Phys. E: Sci. Instrum", Vol. 13, 1980, Seiten 801 bis 813; "IEEE Transactions on Electron Devices", Vol. ED-27, No. 10, Oktober 1980, Seiten 1896 bis 1908). Als ein bevorzugtes Anwendungsgebiet für diese Elemente wird deshalb auch die medizinische Technik, insbesondere die Magnetokardiographie und Magnetoenzephalographie angesehen, wobei magnetische Herz- bzw. Gehirnwellen mit Feldstärken in der Größenordnung von 50 pT bzw. 0,1 pT auftreten ("Biomagnetism - Proceedings Third International Workshop on Biomagnetism, Berlin 1980", Berlin/New York 1981, Seiten 3 bis 31 oder die eingangs erwähnte Veröffentlichung "Rev. Sci. Instrum.").

Eine Vorrichtung zur Messung derartiger biomagnetischer Felder enthält im wesentlichen folgende Komponenten:

1. Ein SQUID als den wesentlichen Feld-Sensor,
2. einen Flußtransformator mit einem sogenannten Gradiometer zur Einkopplung des biomagnetischen Flusses in den Transformator sowie mit einer Koppelspule zur Einkopplung des magnetischen Flusses in das SQUID,
3. elektronische Geräte zur Signalerfassung und -verarbeitung,
4. Abschirmungen für das magnetische Erdfeld und externe Störfelder und
5. ein Kryosystem zur Gewährleistung der Supraleitung von Sensor und Gradiometer.

Der Aufbau und die Funktionsweise entsprechender einkanalig ausgebildeter Vorrichtungen ist bekannt. Bei diesen Vorrichtungen wird das nachzuweisende Magnetfeld, das bis zu 6 Größenordnungen kleiner als externe Störfelder ist, im allgemeinen über eine dreidimensionale Spulenanordnung in den von einem Radiofrequenz (RF)-SQUID gebildeten Kreis mit einem Josephson-Kontakt induktiv eingekoppelt. Dabei sind durch Kombination einer Sensorspule - auch Detektionsspule genannt - mit einer oder mehreren Kompensationsspulen als Gradiometer erster bzw. höherer Ordnung bezeichnete Spulensysteme ausgebildet. Mit solchen Gradiometern können bei entsprechendem manuellen Abgleich die drei Komponenten eines im Spulenbereich homogenen Magnetfeldes bzw. auch dessen Anteil mit homogenem Gradienten weitgehend unterdrückt und das im Gradiometerbereich noch stark inhomogene biomagnetische Nahfeld selektiv erfaßt werden.

Um mit einer derartigen Vorrichtung eine räumliche Feldverteilung zu erhalten, muß zeitlich nacheinander an verschiedenen Orten des zu untersuchenden Bereiches gemessen werden. Hierbei ergibt sich aber die Schwierigkeit, daß über die hierfür erforderliche Meßzeit die Kohärenz der Felddaten nicht mehr gegeben ist und sich außerdem klinisch unzumutbare Meßzeiten ergeben. Es ist deshalb vorgeschlagen worden, statt der bekannten einkanaligen Messung eine mehrkanalige vorzunehmen (vgl. z.B. "Physica", Vol. 107B, 1981, Seiten 29 und 30). Hierbei weist jeder Kanal neben einem RF-SQUID ein abstimmbares supraleitendes Gradiometer und Verknüpfungsglieder zwischen dem SQUID und dem Gradiometer mit einer auch als Koppeltransformator bezeichneten Koppelspule und Verbindungsleitern auf. Bei einer entsprechenden Vorrichtung ergibt sich jedoch ein erheblicher, zeitraubender Aufwand hinsichtlich der Abstimmung der einzelnen Kanäle aufeinander. Gemäß der bekannten Vorrichtung sind nämlich das Gradiometer einerseits und das SQUID mit seiner Koppelspule andererseits jeweils auf einem eigenen Trägerkörper angeordnet, wobei diese Teile über lösbare Verbindungsleiter anzuschließen sind. Mit einer derartigen Verbindungstechnik läßt sich jedoch eine konstante Abstimmung des jeweiligen Flußtransformators nicht von vornherein gewährleisten. Vielmehr ist vor jeder Messung ein Abgleich aller Kanäle erforderlich, die sich auch untereinander beeinflussen. Außerdem ist bei einer solchen Anordnung die mechanische Stabilität der einmal abgestimmten Gradiometer verhältnismäßig gering, so daß der Abgleich durch mechanische Einflüsse leicht wieder aufgehoben wird. Ein weiterer Nachteil der herkömmlichen Gradiometer ist darin zu sehen, daß sie aus Draht aufgebaut sind, der auf einen Festkörper gewickelt wird. Der mechanische Halt der Gradiometer-Drahtspule auf dem Festkörper ist nämlich so gering, daß ein bei Raumtemperatur vorgenommener Abgleich bei einer Abkühlung auf die Temperatur des flüssigen Heliums nicht erhalten bleibt. Darüber hinaus ist auch eine gegenseitige Störung der RF-Kreise unvermeidlich. Die gegenseitige Störung der Kanäle bei benachbarter Anordnung sowie das Eigenrauschen der Einzelkanäle kann zwar durch die Verwendung von Gleichstrom(DC)-SQUIDs an Stelle von RF-SQUIDs reduziert werden (vgl. z.B. "IEEE Transactions on Magnetics", Vol. MAG-19, No. 3, Mai 1983, Seiten 835 bis 844). Jedoch ist auch hier der Abgleich der Einzelkanäle eines entsprechenden, modular aufgebauten Vielkanal-Gradiometer-Systems schwer zu beherrschen.

Die dreidimensional strukturierten Gradiometer der bekannten Vorrichtungen werden im allgemeinen aus supraleitendem Draht auf entsprechenden Wickelkörpern angefertigt, wobei herstellungsbedingte Abgleichtoleranzen von etwa $10^{-3}$ kaum zu unterschreiten sind. Eine Verbesserung dieser Toleranzen wird durch einen nachträglichen mechanischen Abgleich erreicht. Mit diesem Verfahren ist jedoch eine Realisierung von komplexen Gradiometer-Reihen, auch Gradiometer-Feldern (Arrays) genannt, wie sie für mehrkanalige Meßvorrichtungen erforderlich sind, schwer zu erreichen, da ein mechanischer Abgleich bei derartigen Vorrichtungen praktisch nicht durchzuführen ist.

Aus der DE-A-32 47 543 ist darüber hinaus bekannt, derartige Gradiometer-Reihen in Dünnfilm-Planartechnik zu erstellen. Zwar erlaubt diese Technik einen besseren Abgleich als auch die Realisierung komplexerer Strukturen. Hierbei ist jedoch vorausgesetzt, daß die SQUIDs aller Kanäle in der gleichen Ebene erzeugt werden und darüber hinaus die Gradiometer in dieser Ebene zu liegen kommen. Die sich so ergebenden planaren Gradiometer können zwar zu dreidimensionalen Gradiometern höherer Ordnung zusammengesetzt werden; die hierfür erforderliche supraleitende Verbindungstechnik zum Verbinden der Gradiometer untereinander und mit den Koppelspulen bzw. den SQUIDs ist jedoch sehr aufwendig. Außerdem können sich bei derartigen Gradiometern höherer Ordnung auch mechanische Stabilitätsprobleme ergeben.

Ferner ist der US-A-4 280 095 ein Magnetometer mit einem SQUID zu entnehmen, bei dem auf einem dreidimensionalen Trägerkörper in mindestens einem Beschichtungsvorgang supraleitenden Leiterbahnen von Gradiometerspulen einschließlich der Verbindungsleitungen zu den das SQUID kennzeichnenden Josephson-Elementen auszubilden sind. Zur Herstellung dieser Leiterbahnen werden zunächst in einem Zylinder dem Leiterbahnverlauf entsprechende Rillen eingearbeitet, dann wird eine Beschichtung des gesamten Aufbaus mit dem supraleitenden Material vorgenommen und schließlich poliert man dieses supraleitende Material bis auf das sich in den Rillen befindliche wieder ab. Dieser Vorgang muß zum Schließen der Leiterbahnen der Gradiometerspulen wiederholt werden. D.h., mit dem bekannten Verfahren läßt sich ein Magnetometer nur mit einer Vielzahl von einzelnen Schritten herstellen. Das bekannte Verfahren ist dementsprechend aufwendig. Außerdem soll weder eine Koppelspule ausgebildet werden, noch soll sich das SQUID auf einem eigenen Substratkörper befinden.

Gemäß der US-A-4 266 008 kann man supraleitende Leiterbahnen auch durch Fotolithographie mit Maskentechnik ausbilden. Die bekannte Lithographie ist jedoch praktisch nur für ebene Substrate anwendbar.

Aufgabe der vorliegenden Erfindung ist es deshalb, das eingangs genannte Verfahren derart auszugestalten, daß mit ihm ein- oder mehrkanalige Meßvorrichtungen mit entsprechenden dreidimensionalen Gradiometern herzustellen sind, die auf einfache und sichere Weise mit den zugeordneten SQUIDs verknüpft werden können.

Diese Aufgabe wird erfindungsgemäß dadurch gelöst, daß die Gradiometerspulen zumindest mit den Verbindungsleitungen auf einem gemeinsamen dreidimensionalen Trägerkörper in mindestens einem Beschichtungsvorgang aufgebracht werden, dem zur örtlichen Festlegung der entsprechenden Leiterbahnen

- entweder ein Lithographievorgang vorausgeht, wobei zunächst eine flexible Maskenfolie mit den Leiterbahnen entsprechenden Aussparungen auf dem Trägerkörper aufgebracht wird und dann die von der Maskenfolie nicht abgedeckten Teile des Trägerkörpers mit dem supraleitenden Material beschichtet werden,
- oder ein Ätzvorgang nachfolgt, für den zunächst auf den mit dem supraleitenden Material beschichteten Trägerkörper eine flexible Maskenfolie mit einer den Leiterbahnen entsprechenden Struktur aufgebracht wird und bei dem dann die von der Maskenfolie nicht-abgedeckten Teile des supraleitenden Materials wieder abgeätzt werden.

Die mit dem erfindungsgemäßen Verfahren verbundenen Vorteile sind insbesondere darin zu sehen, daß das dreidimensionale Gradiometer mit seinen Gradiometerspulen und der zugeordneten Koppelspule in Dünnfilm-Technik zu erstellen sind, wobei auch die supraleitenden Verbindungsleitungen zwischen der Koppelspule und den Gradiometerspulen ganz oder weitgehend aus dem gleichen supraleitenden Film bestehen wie die Gradiometerspule und gegebenenfalls die Koppelspule selbst. Eine aufwendige Verbindungstechnik zwischen den einzelnen Spulen ist somit vermieden. Außerdem wird auch eine sehr feste Verbindung zwischen dem aus Gradiometer und Koppelspule gebildeten Flußtransformator und dem Trägerkörper erreicht, so daß eine dementsprechend große mechanische Stabilität dieser Anordnung zu gewährleisten ist. Hieraus folgt, daß bei den erfindungsgemäß hergestellten Gradiometern auch beim Abkühlen auf Heliumtemperaturen der einmal vorgenommene Abgleich erhalten bleibt. Darüber hinaus kann der Gradiometerabgleich auch sehr genau vorgenommen werden, da die Strukturierung der entsprechenden supraleitenden Schichten und die Abmessungen des Trägerkörpers sehr genau ausgeführt werden können.

Vorteilhafte Weiterbildungen des erfindungsgemäßen Verfahrens gehen aus den Unteransprüchen hervor.

Zur weiteren Erläuterung der Erfindung wird auf die Zeichnung Bezug genommen, in deren Figuren 1 und 2 jeweils ein Verfahrensschritt zur erfindungsgemäßen Herstellung eines Gradiometers veranschaulicht ist. Die Figuren 3 und 4 zeigen je ein weiteres mit dem erfindungsgemäßen Verfahren herzustellendes Gradiometer.

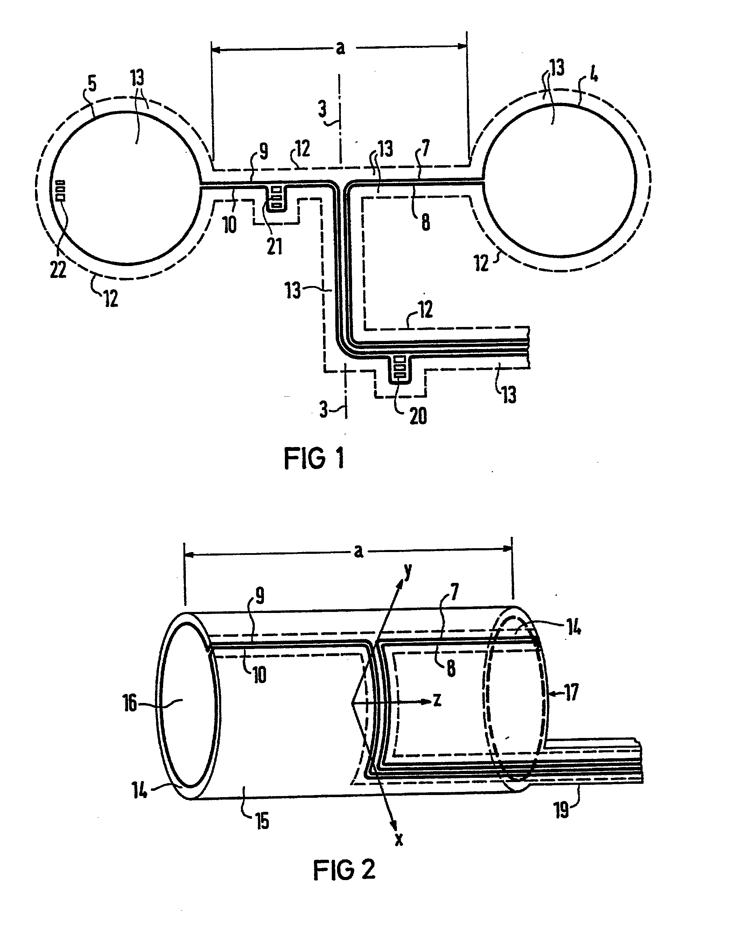

Dreidimensional strukturierte Gradiometer lassen sich z.B. vorteilhaft dadurch herstellen, daß man zunächst mittels einer an sich bekannten Lithographie-Technik auf einem Trägerkörper mit einer der Gradiometergeometrie angepaßten Gestalt eine Beschichtungsmaske aufbaut. Anschließend wird dann in einem Beschichtungsschritt an den von der Maske freigelassenen Stellen des Trägerkörpers, die den Leiterbahnen der Gradiometerspulen und zumindest auch der Verbindungsleitungen entsprechen, das vorgesehene supraleitende Material wie z.B. Niob aufgebracht. Ein besonders vorteilhaftes Verfahren zur Erstellung einer hierfür geeigneten Beschichtungsmaske ist in den Figuren 1 und 2 angedeutet. Dabei ist gemäß dem gewählten Ausführungsbeispiel die Herstellung eines axialen Gradiometers erster Ordnung mit symmetrischem Aufbau angenommen (vgl. die genannte Veröffentlichung "Rev.Sci.Instrum.", Seite 1827, Figur 12d). Die Beschichtungsmaske wird dabei aus einem hinreichend hitzebeständigen und flexiblen Material erstellt. Besonders geeignet sind dünne Polyimid-Folien wie z.B. aus Kapton (eingetragenes Warenzeichen der Firma DuPont).

Gemäß der in Figur 1 schematisch gezeigten Aufsicht auf die zunächst noch ebene, flexible Folie 2 wird in diese zunächst die gesamte Struktur des zu erstellenden Gradiometers einschließlich der erforderlichen Zu- bzw. Verbindungsleitungen in Form von entsprechenden Aussparungen eingearbeitet. Diese Aussparungen sind in der Figur durch durchgezogene Linien veranschaulicht. Dem gewählten Ausführungsbeispiel entsprechend werden in die Folie 2 von ihrer Flachseite her zwei etwa ringförmige, symmetrisch bezüglich einer Symmetrielinie oder -ebene 3 liegende Aussparungen 4 und 5 für die beiden Gradiometerspulen in vorbestimmtem Abstand a zueinander ausgebildet. Während die einem zu untersuchenden Objekt zugewandte Spule gemäß Aussparung 5 auch als Detektionsspule bezeichnet wird, dient die andere Spule gemäß Aussparung 4 in bekannter Weise zu einer Kompensation der magnetischen Störfelder. Diese Spule wird deshalb auch als Kompensationsspule bezeichnet. An den der Symmetrieebene 3 zugewandten Seiten gehen die Aussparungen 4 und 5 in Aussparungen 7 und 8 bzw. 9 und 10 für die Verbindungsleitungen über, die zunächst senkrecht auf die Symmetrieebene 3 zugeführt und dort ein Stück untereinander und zu der Symmetrieebene parallel aus dem Bereich der Aussparungen 4 und 5 herausgeführt sind.

Wie in Figur 1 ferner angedeutet sein soll, wird die noch ebene Folie 2 mit die vorbestimmte dreidimensionale Formgebung erleichternden bzw. ermöglichenden Schlitzen oder Schnitten versehen. Dementsprechend kann man nach der Erstellung der einzelnen Aussparungen für die Leiterbahnen einen von einer gepunkteten Linie 12 umrandeten Bereich, in dem diese Aussparungen verlaufen, aus der Folie 2 heraussohneiden. Dieser mit 13 bezeichnete Bereich wird anschließend gemäß Figur 2 als Beschichtungsmaske 14 auf einen geeigneten Trägerkörper 15 aufgebracht, beispielsweise aufgeklebt. Dieser Trägerkörper kann vorteilhaft aus einem besonderen glasartigen oder keramischen Material wie z.B. aus Vycor (eingetragenes Warenzeichen der Firma Corning Glass Works, Corning, N.Y., USA) bestehen.

Für das gewählte Beispiel eines axialen Gradiometers erster Ordnung hat der Trägerkörper 15 zylinderförmige oder auch quaderförmige Gestalt mit planparallelen Stirnflächen 16 und 17 und abgerundeten Kanten. Die die Verbindungsleitungen zwischen den verschiedenen Gradiometerebenen festlegenden Teile der Maske 14 lassen sich dann ohne Schwierigkeit um diese Kanten legen. Außerdem werden die zu einem getrennt angeordneten, in der Figur nicht ausgeführten SQUID führenden Verbindungsleitungen zweckmäßigerweise auf einem Verlängerungsteil 19 des Trägerkörpers 15 nach einem Aufkleben des entsprechenden Bereiches der Beschichtungsmaske auf diesem Teil ausgebildet.

Bei den erfindungsgemäß herzustellenden Gradiometern ist mittels einer geeigneten Führung und Gestaltung der Verbindungsleiterbahnen nachträglich ein verhältnismäßig einfacher, beispielsweise mittels eines Lasers durchzuführender Abgleich bezüglich der x- und y-Komponenten des mit dem Gradiometer zu detektierenden Magnetfeldes durchzuführen. Der z-Abgleich des Gradiometers kann an der Stirnseite vorgenommen werden. Dabei ist angenommen, daß die z-Achse eines entsprechenden, in Figur 2 eingetragenen x-y-z-Koordinatensystems mit der Zylinderachse des Trägerkörpers 15 übereinstimmt, während die x- und y-Achsen eine Mittelebene aufspannen, in der die Symmetrieebene 3 gemäß Figur 1 liegt. Als Abgleichstellen kann jeweils für eine x-, y- und z-Kompensation eine Mehrzahl von Ringstrukturen abgestufter Größe innerhalb der stirnseitigen Schleife der Gradiometerspule bzw. zwischen den entsprechenden Hin- und Rückleitungen vorgesehen werden. Die entsprechenden Aussparungen in der Folie 2 sind in Figur 1 mit 20 bzw. 21 bzw. 22 bezeichnet. Die somit herzustellenden Ringstrukturen können dann nach Kontrollmessungen, soweit erforderlich, mittels des Lasers durchtrennt werden.

Die mit der Beschichtungsmaske gemäß den Figuren 1 und 2 auszubildenden Gradiometer erster Ordnung sind stapelbar, wodurch sich auch Gradiometer zweiter Ordnung kombinieren lassen. Auch planare Gradiometer erster Ordnung lassen sich in gleicher Weise durch Realisierung von zwei Ebenen zu Gradiometern zweiter Ordnung vom gemischten Axial/Planar-Typ kombinieren. Auch Gradiometer-Reihen lassen sich entsprechend ausbilden.

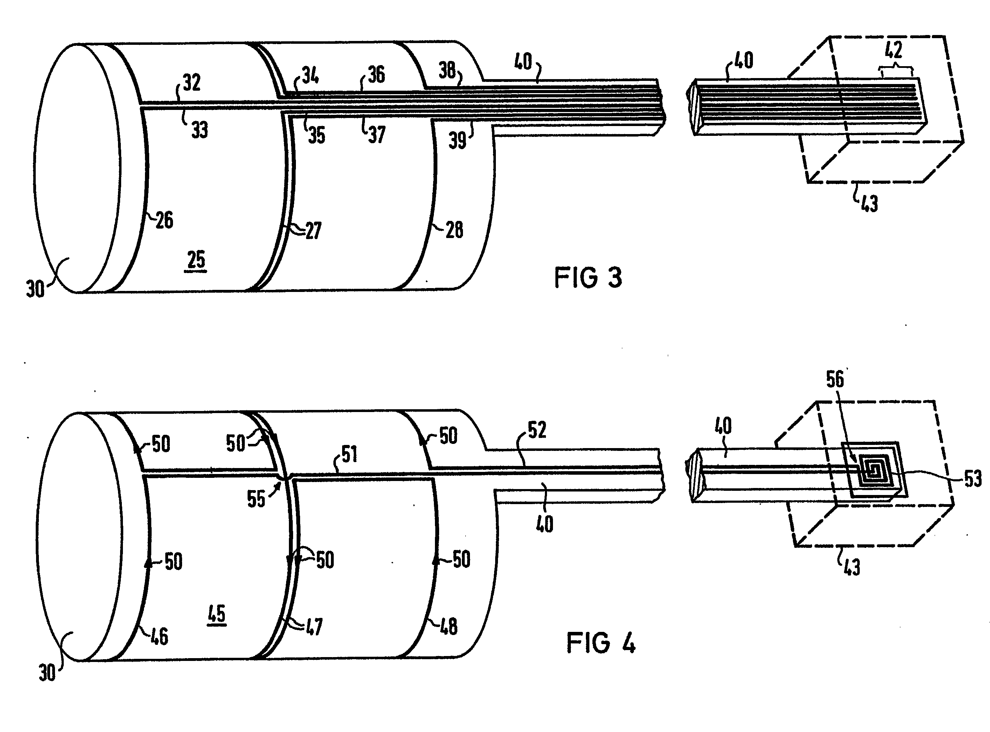

Bei dem in Figur 3 schematisch als Schrägansicht angedeuteten supraleitenden Gradiometer 25 handelt es sich um eine symmetrische Ausführungsform zweiter Ordnung (vgl. die genannte Veröffentlichung "Rev.Sci. Instrum.", Seite 1827, Figur 12f). Dementsprechend enthält das Gradiometer 25 drei Spulen 26, 27 und 28 mit einem Windungszahlverhältnis 1:-2:1, wobei durch das "-"-Zeichen die umgekehrte Stromflußrichtung in der Spule 27 im Vergleich zu den Spulen 26 und 28 zum Ausdruck kommt. Die einem zu untersuchenden Objekt zugewandte Spule 26 stellt die Detektionsspule dar, während die übrigen Spulen 27 und 28 als Kompensationsspulen eingesetzt werden. Die Spulen 26 bis 28, die auf einem zylindrischen Trägerkörper 30 aufgebracht sind, der beispielsweise aus einem keramischen Material oder Si besteht, sind über jeweils zwei Verbindungsleitungen (32 bis 39) angeschlossen. Die somit acht Verbindungsleitungen sind bezüglich des zylindrischen Trägerkörpers 30 axialer Richtung auf einem schmalen, stegartigen Verlängerungsteil 40 des Trägerkörpers 30 angebracht und führen zu einem Bereich 42, der von einer in der Figur durch gestrichelte Linien angedeuteten supraleitenden Abschirmung 43 umgeben ist. Innerhalb dieses abgeschirmten Bereiches 42 sind die Verbindungsleitungen 32 bis 39 untereinander und mit einer nicht ausgeführten Koppelspule kontaktiert, über welche das detektierte magnetische Feld in ein ebenfalls nicht dargestelltes SQUID einzukoppeln ist. Das SQUID und die Koppelspule befinden sich dabei auf einem eigenen Substratkörper, der an dem Verlängerungsteil 40 des Trägerkörpers 30 zu befestigen ist.

Das Gradiometer 25 mit seinen Spulen 26 bis 28 und den entsprechenden Verbindungsleitungen 32 bis 39 werden erfindungsgemäß mit einer Dünnoder Dickfilmtechnik hergestellt. Hierzu werden die entsprechenden Leiterbahnen, die gemäß dem Ausführungsbeispiel der Figur 3 kreuzungsfrei in einer einzigen Ebene geführt sind, zunächst durch einen Lithographievorgang freigelegt.

Demensprechend kann beispielsweise der Trägerkörper 30 mit seinem Verlängerungsteil 40 belackt und die Lackschicht anschließend strukturiert werden. Hierzu wird vorteilhaft ein Laser-Trimmer vorgesehen. Anschließend wird dann die Metallisierung der Leiterbahnen durch z.B. Aufdampfen des vorgesehenen supraleitenden Materials vorgenommen. Zuletzt werden noch mittels einer an sich bekannten Abhebetechnik die noch belackten Oberflächenteile des Trägerkörpers 30 und des Verlängerungsteils 40 freigelegt.

Neben diesem Herstellungsverfahren für die Leiterbahnen kann man auch zunächst den Trägerkörper und sein Verlängerungsteil mit dem supraleitenden Material bedampfen und anschließend mittels einer an sich bekannten Ätztechnik aus der erhaltenen aufgedampften Schicht die einzelnen Leiterbahnen ausbilden, indem man zumindest die zu den Leiterbahnen benachbarten Bereiche der Bedampfungsschicht herausätzt. Diese Herausätzung kann z.B. durch reaktives Ionenätzen vorgenommen werden.

Bei dem in Figur 3 dargestellten, mit dem erfindungsgemäßen Verfahren herzustellenden Gradiometer zweiter Ordnung wurde davon ausgegangen, daß die Leiterbahnen lithographisch in nur einer einzigen Lithographieebene hergestellt werden sollen. Bei diesem Verfahren ergibt sich dann zwangsläufig eine den einzelnen Spulen des Gradiometers entsprechende Anzahl von Doppelleitungen, die über das Verlängerungsteil 40 des Trägerkörpers 30 an die Koppelspule und somit das SQUID anzukoppeln sind. Werden jedoch zwei Lithographieebenen für die Herstellung des Gradiometers vorgesehen, so daß dann auch Überkreuzungen möglich sind, so läßt sich die Anzahl der aus dem Gradiometer herausgeführten Verbindungsleitungen dementsprechend verringern und vorteilhaft auch gleichzeitig die erforderliche Koppelspule herstellen. Ein Ausführungsbeispiel eines derartigen Gradiometers ist in Figur 4 in einer Figur 3 entsprechenden Darstellung veranschaulicht. Dabei sind mit Figur 3 übereinstimmende Teile mit den gleichen Bezugszeichen versehen. Das allgemein mit 45 bezeichnete Gradiometer enthält eine Detektionsspule 46 sowie zwei Kompensationsspulen 47 und 48. Diese Spulen sind in bekannter Weise so hintereinandergeschaltet, daß sich die durch Pfeile 50 an ihnen angedeuteten Stromflußrichtungen ergeben und nur zwei Verbindungsleitungen 51 und 52 zu einer Koppelspule 53 erforderlich sind. Diese Koppelspule 53 ist gleichzeitig mit den übrigen Leiterbahnen der Spulen 46 bis 48 und den Verbindungsleitungen 51 und 52 am Ende des Verlängerungsteiles 40 des Trägerkörpers 30 hergestellt. Dies ist dadurch möglich, daß für die Leiterbahnen der Kompensationsspule sowie für die Koppelspule 53 mit der Lithographie in zwei Ebenen Überkreuzungen 55 bzw. 56 ausgebildet sind. Auf die Koppelspule 53 kann dann das sich auf einem getrennten Substratkörper befindende SQUID direkt aufgebracht und beispielsweise dort verklebt werden.

Die in den Figuren 2 bis 4 dargestellten Gradiometer mit den ihnen zuzuordnenden SQUIDs stellen jeweils ein Modul für einen Detektionskanal einer Meßvorrichtung dar. Mehrkanalige Vorrichtungen lassen sich dann mit einer entsprechenden Anzahl solcher Gradiometer-SQUID- Module bis zu der erwünschten Reihe (Array) in bekannter Weise zusammensetzen.

**Patentansprüche**

1. Verfahren zur Herstellung eines Gradiometers aus supraleitendem Material mit dreidimensionaler Gestalt für eine Vorrichtung zur ein- oder mehrkanaligen Messung von Magnetfeldern mit Feldstärken bis unter $10^{-10}$ T, insbesondere unter $10^{-12}$ T, bei dem die Gradiometerspulen (26 bis 28; 46 bis 48) vorbestimmter Abmessungen auf einem Trägerkörper (15, 19; 30, 40) angeordnet und mittels Verbindungsleitungen (32 bis 39; 51, 52) und einer Koppelspule mit einem auf einem eigenen Substratkörper befindlichen supraleitenden Quanten-Interferenz-Element (SQUID) in magnetisch koppelnder Weise verbunden werden, dadurch gekennzeichnet, daß die Gradiometerspulen (26 bis 28; 46 bis 48) zumindest mit den Verbindungsleitungen (32 bis 39; 51, 52) auf einem gemeinsamen dreidimensionalen Trägerkörper (15, 19; 30, 40) in mindestens einem Beschichtungsvorgang aufgebracht werden, dem zur örtlichen Festlegung der entsprechenden Leiterbahnen

– entweder ein Lithographievorgang vorausgeht, wobei zunächst eine flexible Maskenfolie (14) mit den Leiterbahnen entsprechenden Aussparungen (4, 5, 7 bis 10) auf dem Trägerkörper (15, 19) aufgebracht wird und dann die von der Maskenfolie nicht abgedeckten Teile des Trägerkörpers mit dem supraleitenden Material beschichtet werden,

– oder ein Ätzvorgang nachfolgt, für den zunächst auf den mit dem supraleitenden Material beschichteten Trägerkörper (15, 19) eine flexible Maskenfolie mit einer den Leiterbahnen entsprechenden Struktur aufgebracht wird und bei dem dann die von der Maskenfolie nicht-abgedeckten Teile des supraleitenden Materials wieder abgeätzt werden.

2. Verfahren nach Anspruch 1, dadurch gekennzeichnet, daß die Maskenfolie (14) auf den Trägerkörper (15, 19) aufgeklebt wird.

3. Verfahren nach Anspruch 1 oder 2, dadurch gekennzeichnet, daß für die Maskenfolie (14) ein hitzebeständiges Material vorgesehen wird.

4. Verfahren nach Anspruch 3, dadurch gekennzeichnet, daß eine dünne Polyimid-Folie für die Maskenfolie (14) vorgesehen wird.

5. Verfahren nach einem der Ansprüche 1 bis 4, dadurch gekennzeichnet, daß die Maskenfolie (14) mit das Aufbringen auf den dreidimensionalen Trägerkörper (15, 19) erleichternden bzw. ermöglichenden Schlitzen oder Schnitten (12) versehen wird.

## Claims

1. Method of manufacturing a gradiometer of superconducting material with a three-dimensional structure for a device for single or multi-channel measurement of magnetic fields with field strengths to below $10^{-10}$ T, in particular below, $10^{-12}$ T, with which the gradiometer coils (26 to 28; 46 to 48) of predetermined dimensions are arranged on a carrier body (15, 19; 30, 40) and are connected in a magnetically coupling manner, by means of connecting lines (32 to 39; 51, 52) and a coupling coil, to a superconducting quantum-interference-device (SQUID), located on an individual substrate body, characterised in that the gradiometer coils (26 to 28; 46 to 48) are applied at least with the connecting lines (32 to 39; 51, 52) to a common three-dimensional carrier body (15, 19; 30, 40) in at least one coating process, in addition to which, for determining the corresponding printed lines

- there is either a lithographic process preceding the coating process, wherein firstly a flexible mask film (14) with apertures (4, 5, 7 to 10) corresponding to the printed lines is applied to the carrier body (15, 19) and then the parts of the carrier body, not covered by the mask film, are coated with the superconducting material,
- or an etching process following the coating process, for which a flexible mask film with a structure corresponding to the printed lines is then applied to the carrier body (15, 19) coated with the superconducting material and in which the parts of the superconducting material, not covered by the mask film, are then etched again.

2. Method according to claim 1, characterised in that the mask film (14) is stuck to the carrier body (15, 19).

3. Method according to claim 1 or 2, characterised in that a heat-resistant material is provided as the mask film (14).

4. Method according to claim 3, characterised in that a thin polyimide film is provided as the mask film (14).

5. Method according to one of claims 1 to 4 characterised in that the mask film (14) is provided with slits or cuts easing or enabling the application on the three-dimension carrier body (15, 19).

## Revendications

1. Procédé pour la construction d'un gradiomètre à supraconduction, possédant une conformation tridimensionnelle pour un dispositif servant à la mesure, à canal unique ou à canaux multiples, de champs magnétiques possédant des intensités jusqu'à en dessous de $10^{-10}$ T, en particulier en dessous de $10^{-12}$ T, dans lequel les bobines du gradiomètre (26 à 28; 46 à 48) ayant des dimensions prédéterminées, sont disposées sur un corps de support (15, 19; 30, 40) et sont reliées, à l'aide de conducteurs de liaison (32 à 39; 51, 52) et d'une bobine de couplage, et par un mode de couplage magnétique, à un dispositif du type interféromètre quantique à supraconduction (SQUID) qui se trouve sur un corps de substrat qui lui est propre, caractérisé par le fait que les bobines du gradiomètre (26 à 28; 46 à 48), avec au moins les conducteurs de liaison (32 à 39; 51, 52), sont déposées sur un corps de support tridimensionnel commun (15, 19; 30, 40) en au moins un processus de revêtement qui, en vue du repérage local des pistes conductrices correspondantes,

- est précédé par un processus litographique au cours duquel une feuille flexible formant masque (14), comportant des rainures (4, 5, 7 à 10) qui correspondent aux pistes conductrices est d'abord disposée sur le corps de support (15, 19) et qu'ensuite les parties du corps de support qui ne sont pas recouvertes par la feuille formant masque, sont revêtues d'un matériau supraconducteur,
- ou est suivi d'un processus de corrosion pour lequel est d'abord déposée, sur le corps de support (15, 19) qui est revêtu du matériau supraconducteur, une feuille flexible formant masque et possédant une structure qui correspond aux pistes conductrices, et au cours duquel sont ensuite enlevées, aussi par corrosion, les parties du matériau supraconducteur qui ne sont pas recouvertes par la feuille formant masque.

2. Procédé selon la revendication 1, caractérisé par le fait que la feuille formant masque (14) est collée sur le corps de support (15, 19).

3. Procédé selon la revendication 1 ou 2, caractérisé par le fait qu'il est prévu, pour la feuille formant masque (14), un matériau thermo-résistant.

4. Procédé selon la revendication 3, caractérisé par le fait qu'il est prévu, pour la feuille formant masque (14), une feuille de polyimide.

5. Procédé selon l'une des revendications 1 à 4, caractérisé par le fait que la feuille formant masque (14) est pourvue de fentes ou d'entailles qui facilitent ou permettent son application sur le corps de support tridimensionnel (15, 19).

EP 0 184 670 B1

FIG 1

FIG 2

FIG 3

FIG 4

EP 0 184 670 B1